# EUROPEAN PATENT SPECIFICATION

(11) **EP 4 188 864 B1**
(45) Date of publication and mention of the grant of the patent: **04.03.2026**
(21) Application number: 20947155.6
(22) Date of filing: 31.07.2020
(51) Int. Cl.: G05B 17/02, G05B 19/418, B66F 9/00, G05D 1/00, B66F 9/06, G06F 11/36, G06F 30/15, G06F 30/20

(54) **METHOD AND APPARATUS FOR EMULATING AUTOMATED GUIDED VEHICLE (AGV) SYSTEM**
VERFAHREN UND VORRICHTUNG ZUR EMULATION EINES SYSTEMS MIT EINEM AUTOMATISCH GEFÜHRTEN FAHRZEUG
PROCÉDÉ ET APPAREIL POUR ÉMULER UN SYSTÈME DE VÉHICULE À GUIDAGE AUTOMATIQUE (VGA)

(43) Date of publication of application: 07.06.2023
(73) Proprietor: Siemens Industry Software Ltd., 7019900 Airport City (IL)
(72) Inventor: MANN, Zachi, 7680400 Mazkeret Batya (IL); MADVIL, Rahav, 7533916 Rishon Lezion (IL); XU, Wei Feng, Shanghai 200940 (CN); LI, Jing, Shanghai 201208 (CN)
(74) Representative: Siemens Patent Attorneys
(86) International application number: PCT/IB2020/057254
(87) International publication number: WO 2022/023797

(56) References cited:
- DE-A1- 102018 116 611
- US-A1- 2009 182 537
- US-A1- 2011 093 134
- US-A1- 2012 123 614
- US-A1- 2012 123 614
- US-A1- 2014 248 589
- US-A1- 2017 092 000
- PIARDI LUIS ET AL: "ARENA-Augmented Reality to Enhanced Experimentation in Smart Warehouses", SENSORS, vol. 19, no. 19, 4 October 2019 (2019-10-04), pages 4308, XP055904685, DOI: 10.3390/s19194308
- PIARDI LUIS, KALEMPA VIVIAN CREMER, LIMEIRA MARCELO, SCHNEIDER DE OLIVEIRA ANDRÉ, LEITÃO PAULO: "ARENA—Augmented Reality to Enhanced Experimentation in Smart Warehouses", SENSORS, vol. 19, no. 19, pages 4308, XP055904685, DOI: 10.3390/s19194308

## Description

### BACKGROUND

### Technical Field

The present disclosure relates to the field of industrial manufacturing technologies, and more particularly, to a method, an apparatus, a computing device, a computer-readable storage medium, and a program product for emulating an AGV system.

### Related Art

With the development of positioning and navigation technologies, automated guided vehicles (AGVs) are increasingly used in industrial environments, for example, in factories, to move materials between a warehouse and a production line or between production lines to improve transport efficiency.

The US 2012/0123614 A1 discloses a system to virtualize industrial vehicles to automate the execution of vehicle independent task in a physical environment including also the utilization of AGVs. The DE 2018 116 611 A1 discloses a system designed to manage and optimize the flow of materials within a warehouse comprising features like a centralized control system, integration of automated machinery, sensor integration, and real-time data processing. The article "ARENA- Augmented Reality to Enhanced Experimentation in Smart Warehouse" (published in www.rndpi.com/journal/sensors on 4 October 2019) discloses a technique where Augmented Reality is employed to enhance the capabilities of swarm robots, allowing box handling and virtual forklift whereby virtual laser range finders are also utilized.

When an AGV performs a material transport task, the AGV may generally interact with other machines or mechanical devices running in a factory. The machines or mechanical devices may be automated devices located on a motion path of the AGV, such as an automated door, a lift, and a signal lamp, or other automated devices related to the transport task performed by the AGV, such as a conveyor belt, a robot, an elevator, and the like. In addition, when transporting the materials in the factory, the AGV may often collide with an environmental object, for example, a static object such as an enclosure or a box and a dynamic object such as a worker or other AGVs.

Interaction between the AGV and other automated devices needs to be validated and debugged in order to achieve a smooth material transport operation and improve productivity of the factory. Currently, an AGV deployment engineer generally validates and debugs on site the interaction between the AGV and the other automated devices according to experience, and optimizes a routing and scheduling algorithm of a scheduling manager.

Besides, in some existing emulators, an AGV controller is virtualized to validate and debug a control algorithm of the AGV, or separately validate the routing and scheduling algorithm of the scheduling manager.

### SUMMARY

When interaction between an AGV and other automated devices is validated and debugged by an AGV deployment engineer, it usually takes a lot of time and efforts. Meanwhile, a deployment process of the AGV often requires shutdown of a factory, which may affect normal production of the factory and reduce productivity. Besides, such debugging is highly dependent on personal experience and prior preparation of the engineer, which brings great uncertainty to estimation of downtime of the factory.

On the other hand, an existing emulator can only separately validate and debug an AGV controller or a routing and scheduling algorithm, but the emulator can neither validate the interaction between the AGV and the other automated devices, nor simultaneously validate the AGV controller, the routing and scheduling algorithm, and the interaction between the AGV and the other automated devices. Moreover, in case that the AGV controller is fully virtualized, an emulation result in the emulator depends on parameters set manually and is generally inconsistent with an actual situation.

The invention is set out in the appended set of claims.

A method for emulating an AGV system is proposed in a first embodiment of the present disclosure, including: obtaining sensor data of a virtual AGV in an emulation environment; determining a device state of a virtual device interacting with the virtual AGV in the emulation environment; sending the sensor data and the device state to the AGV system, and receiving AGV motion control information and device operation information from the AGV system, where the AGV motion control information and the device operation information are generated by the AGV system based on the sensor data and the device state; and controlling motion of the virtual AGV and the virtual device in the emulation environment based on the AGV motion control information and the device operation information respectively.

In the embodiment, the interaction between the AGV and the automated devices can be emulated, then the interaction can be validated and debugged, and transport operation time, order, and congestion can be checked, thus optimizing the routing and scheduling algorithm. Therefore, with the method of the present disclosure, time and efforts spent by a deployment engineer on deployment and debugging are reduced, and factory downtime is decreased. Besides, with the method of the present disclosure, an entire AGV system and an AGV sensor, not just a part of the AGV system, can be validated.

An apparatus for emulating an AGV system is proposed in a second embodiment of the present disclosure, including: a sensor detection unit, configured to obtain sensor data of a virtual AGV in an emulation environment; a state determining unit, configured to determine a device state of a virtual device interacting with the virtual AGV in the emulation environment; a data communications unit, configured to send the sensor data and the device state to the AGV system, and receive AGV motion control information and device operation information from the AGV system, where the AGV motion control information and the device operation information are generated by the AGV system based on the sensor data and the device state; and a motion control unit, configured to control motion of the virtual AGV and the virtual device in the emulation environment based on the AGV motion control information and the device operation information respectively.

A computing device is proposed in a third embodiment of the present disclosure. The computing device includes: a processor; and a memory, configured to store a computer-executable instruction, the computer-executable instruction, when executed, causing the processor to perform the method in the first embodiment.

A computer-readable storage medium is proposed in a fourth embodiment of the present disclosure. The computer-readable storage medium has a computer-executable instruction stored therein, the computer-executable instruction being used to perform the method in the first embodiment.

A computer program product is proposed in a fifth embodiment of the present disclosure. The computer program product is tangibly stored in a computer-readable storage medium and includes a computer-executable instruction, the computer-executable instruction, when executed, causing at least one processor to perform the method in the first embodiment.

### BRIEF DESCRIPTION OF THE DRAWINGS

Features, advantages, and other aspects of various embodiments of the present disclosure will become more apparent with reference to the accompanying drawings and the following detailed description. Several embodiments of the present disclosure are shown here in an exemplary rather than restrictive manner. In the drawings,
FIG. 1 illustrates an emulation method for an AGV system according to an embodiment of the present disclosure;
FIG. 2 illustrates an emulation system for implementing the emulation method in FIG. 1 according to an embodiment of the present disclosure;
FIG. 3(a) to FIG. 3(b) illustrate schematic components of a virtual device and a virtual AGV in the embodiment of FIG. 2 respectively;
FIG. 4(a) to FIG. 4(e) illustrate 3D models of one AGV and a plurality of automated devices interacting with the AGV in the embodiment of FIG. 2;
FIG. 5(a) to FIG. 5(d) illustrate kinematic models of the AGV and the plurality of automated devices interacting with the AGV in FIG. 4;
FIG. 6 is a schematic diagram of a virtual lidar of a virtual AGV in FIG. 4(a) displayed through a display interface;
FIG. 7 illustrates a schematic emulation environment according to the embodiment of FIG. 2 displayed through a display interface;
FIG. 8(a) to FIG. 8(b) are schematic diagrams of collision of a virtual AGV with a virtual device and with an environmental object in FIG. 4(a) displayed through a display interface respectively;
FIG. 9 illustrates another emulation system for implementing the emulation method in FIG. 1 according to an embodiment of the present disclosure;
FIG. 10 illustrates an apparatus for emulating an AGV system according to an embodiment of the present disclosure; and
FIG. 11 is a block diagram of a computing device for emulating an AGV system according to an embodiment of the present disclosure.

### DETAILED DESCRIPTION

Various exemplary embodiments of the present disclosure are described below in detail with reference to the accompanying drawings. Although exemplary methods and apparatuses described below include software and/or firmware executed in hardware of other components, it should be noted that, the examples are only illustrative and should not be considered as restrictive. For example, it is considered that any or all hardware, software, and firmware components can be implemented in hardware exclusively, in software exclusively, or in any combination of hardware and software. Therefore, although the exemplary methods and apparatuses have been described below, it is easy for a person skilled in the art to understand that the examples provided are not used to limit manners for implementing the methods and apparatuses.

In addition, architectures, functions, and operations of possible implementations of methods and systems according to various embodiments of the present disclosure are illustrated in the flowcharts and the block diagrams of the accompanying drawings. It should be noted that functions labeled in the blocks may also occur in an order different from that as labeled in the accompanying drawings. For example, two successive blocks may be basically performed in parallel, or they may be performed in an opposite order sometimes, depending on the functions involved. It should also be noted that each block in the block diagrams and/or the flowcharts, and a combination of blocks in the block diagrams and/or the flowcharts may be implemented using a dedicated hardware-based system for executing specified functions or actions, or may be implemented using a combination of dedicated hardware and computer instructions.

The terms "include" and "comprise" and similar terms used herein are open terms, i.e., "include/comprise, but not limited to," indicating that other content may also be included. The term "based on" is "based at least in part on." The term "an embodiment" indicates "at least one embodiment," the term "another embodiment" indicates "at least one additional embodiment," and so on.

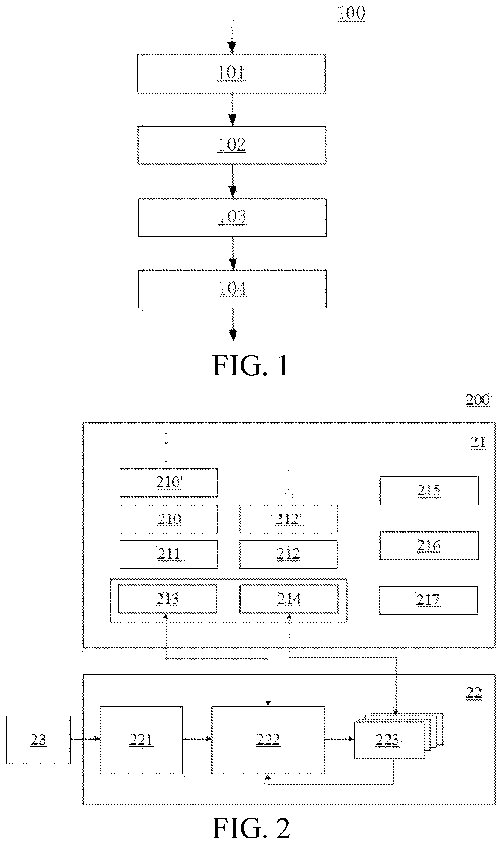

FIG. 1 illustrates a method for emulating an automated guided vehicle (AGV) system according to an embodiment of the present disclosure. The AGV system is an actual system in a factory, and at least includes a scheduling manager and an AGV controller. The scheduling manager schedules and routes an AGV according to an AGV task, AGV states received from various AGV controllers, and corresponding device states received by respective automated devices interacting with an AGV when the task is performed. The scheduling manager generates AGV control information and device operation information, which are used to control motion of the AGV and automated device interacting with the AGV respectively. The AGV controller controls motion of a motor of the AGV according to the AGV control information and a current position and a current orientation of the AGV.

Referring to FIG. 1, a method 100 starts from step 101. In step 101, sensor data of a virtual AGV in an emulation environment is obtained. An emulation environment consistent with an actual factory environment is built, and a material transport scene in a factory is emulated. The emulation environment includes a virtual AGV, a virtual device related to a transport task performed by the virtual AGV (e.g., a conveyor belt, a robot, an elevator, etc.), a virtual device located on a motion path of the virtual AGV (e.g., an automated door, a lift, a signal lamp, etc.), and an environmental object around the virtual AGV (e.g., an enclosure, a box, a worker, other AGVs, etc.). The sensor data of the virtual AGV in the emulation environment may be used to calculate a position and an orientation of the virtual AGV in the emulation environment. In some embodiments, the sensor data may be periodically obtained to periodically calculate the position and the orientation of the virtual AGV in the emulation environment.

In some embodiments, step 101 of obtaining sensor data of a virtual AGV in an emulation environment further includes (not shown in FIG. 1): obtaining the sensor data based on a sensor model of the virtual AGV, the sensor model of the virtual AGV including a position and parameters of a virtual sensor of the virtual AGV. The virtual AGV includes three models: a 3D model, a kinematic model, and a sensor model. The 3D model describes a contour of an AGV body, i.e., a shape and a size. The kinematic model describes motion relations and motion parameters of moving components of the AGV body, such as connection relationships, motion types, motion directions, and motion limits of the moving components. The sensor model describes a position of an AGV sensor relative to the AGV body and sensor parameters. The AGV sensor may be a lidar, a security grating, a trajectory tracker, a camera, and so on, so the sensor parameters may vary according to different types of sensors. For example, for the lidar, the sensor parameters may include scanning wiring harnesses (e.g., 12/24/48 bundles), a scanning angle (e.g., 120°/180°/360°), and a wiring-harness effective distance (e.g., 1/2/5 m). In order to obtain the sensor data of the virtual AGV, similar to the virtual AGV, virtual devices and/or environmental objects around the virtual AGV also include a 3D model. If the virtual devices and/or the environmental objects are movable, a kinematic model is further included.

Therefore, the sensor data can be obtained according to the position of the virtual sensor and the parameters of the virtual sensor defined in the sensor model of the virtual AGV. When there is a virtual device and/or an environmental object within a detection range of the virtual sensor (for example, within a scanning angle range of the lidar or within a field of view of the camera), the sensor data may be obtained further using external contour data defined by a 3D model of the virtual device and/or the environmental object. Besides, the obtained sensor data may vary according to a different sensor type represented by the sensor model. For example, for the lidar, the sensor data may be a set of data corresponding to a quantity of the wiring harnesses of the lidar and having a value less than or equal to the wiring-harness effective distance. For another example, for the security grating, the sensor data may be a value of 0 or 1, while for the camera, the sensor data may be an RGB image or an RGB-D image.

In the above manner, an AGV sensor and other virtual devices and/or environmental objects in an actual factory are emulated in an emulation environment, so the sensor data obtained is close to sensor data obtained by an AGV in the actual factory.

Still referring to FIG. 1, in step 102. a device state of a virtual device interacting with the virtual AGV in the emulation environment is determined. The virtual device interacting with the virtual AGV may be a virtual device related to a transport task performed by the virtual AGV (e.g., a conveyor belt, a robot, an elevator, etc.) and a virtual device located on a motion path of the virtual AGV (e.g., an automated door, a lift, a signal lamp, etc.). The device state may vary according to a different type of the virtual device. For example, for the automated door, the device state may include an opened state, a being opened state, a closed state, a being closed state, or a waiting state. For another example, for the lift, the device state may include a floor where the lift is located and a lift door being in an opened state, a being opened state, a closed state, a being closed state, or a waiting state. For the conveyor belt, the device state may include running and non-running states. The device state is provided for the scheduling manager, so that the scheduling manager controls motion of the virtual device and the virtual AGV respectively to implement interaction between the virtual AGV and the virtual device. It should be noted that step 102 may be executed sequentially or synchronously with step 101, or, in more cases, independently of step 101.

In some embodiments, step 102 of determining a device state of a virtual device interacting with the virtual AGV in the emulation environment further includes: obtaining state data of the virtual device based on a sensor model of the virtual device, the state data representing relative motion between moving components of the virtual device, where the sensor model of the virtual device includes a position and parameters of a virtual sensor of the virtual device; and determining the device state of the virtual device according to the state data. In the embodiments, similar to the virtual AGV, three models, i.e., a 3D model, a kinematic model, and a sensor model, are built for the virtual device. The 3D model describes a contour of the virtual device, i.e., a shape and a size. The kinematic model describes motion relationships and motion parameters of moving components of the virtual device, such as connection relationships, motion types, motion directions, and motion limits of the moving components. The sensor model describes a position (e.g., at joints of the moving components) and parameters of a virtual sensor, which is used to detect relative motion between the moving components. For example, for the automated door, the virtual sensor may be a virtual lidar at a joint between a door frame and a door leaf, and the parameters of the virtual sensor may include a scanning wiring harness, a scanning angle, and a wiring-harness effective distance. Alternatively, the virtual sensor may be a virtual position sensor (sensing movement of a position of a door plate) located at the joint between the door frame and the door leaf, and relative motion of the door frame and the door leaf is detected through changes of a coordinate position of the door leaf. For another example, for the lift, the virtual sensor may be a virtual height sensor on a car or on the ground and a virtual lidar or a virtual position sensor located at a joint between a door frame and a door leaf of the car. The obtained state data may vary according to a different sensor type represented by the sensor model of the virtual device. For example, for the automated door, the state data may be data (e.g., 0-100) representing an opening degree of the automated door, while for the lift, the state data may be data representing a floor number and an opening degree of a car. After the state data of the virtual device is obtained, a device state of the virtual device is determined based on the state data. As mentioned above, the device state may vary according to different virtual devices. The state data may be mapped to a different device state according to a preset rule.

In the above manner, automated devices in an actual factory that interact with an AGV when a transport task is performed are emulated in an emulation environment, and device states of the virtual automated devices can be obtained, so that a virtual AGV and virtual devices interacting with the virtual AGV are controlled respectively. Therefore, interaction between the AGV and the automated devices can be emulated almost practically.

Still referring to FIG. 1, in step 103, the sensor data and the device state are sent to the AGV system, and AGV motion control information and device operation information are received from the AGV system, where the AGV motion control information and the device operation information are generated by the AGV system based on the sensor data and the device state. The AGV system is an actual system outside the emulation environment. According to a kinematic model of an AGV, the AGV motion control information may be motor control information or position control information. The motor control information may include a rotation direction and a rotation angle of a motor of the virtual AGV, and the position control information may include an entire motion direction, a rotation direction, and a rotation angle of the virtual AGV and a travel speed of the virtual AGV. The device operation information may include a target position and an execution action of the virtual device, for example, opening/closing of the automated door, a floor to be reached by the lift and opening/closing of the lift, lifting/falling of the elevator, and so on.

In some embodiments, the AGV system includes an AGV controller and a scheduling manager. Sensor data of the virtual AGV is sent to the AGV controller, and the device state of the virtual device is sent to the scheduling manager. Different communications interfaces may be established respectively according to an interface definition (e.g., TCP/IP, OPC, Profinet, etc.) of the AGV controller and an interface definition (e.g., TCP/IP, OPC, Profinet, etc.) of the scheduling manager.

In some embodiments, the sensor data of the virtual AGV is periodically sent to the AGV controller, and the device state of the virtual device is sent to the scheduling manager in response to a request from the scheduling manager. Specifically, after the AGV controller receives the sensor data of the virtual AGV, a current position and a current orientation of the virtual AGV in the emulation environment may be calculated according to the sensor data and local map data of the AGV controller, that is, the virtual AGV is positioned. Next, the AGV controller periodically sends, in response to the request from the scheduling manager, the current position and the current orientation of the virtual AGV, a transport task being performed by the virtual AGV, a target position, and speed parameters (e.g., an acceleration, a maximum speed, a motor speed, etc.), power and elapsed runtime of the virtual AGV, and other information as state data of the AGV to the scheduling manager.

The scheduling manager determines, according to AGV state data from the AGV controller and a route map of the transport task being performed by the virtual AGV, a virtual device to be operated, and sends a device state request to an emulator. The emulator sends a device state of the virtual device to the scheduling manager in response to the request. Afterwards, the scheduling manager generates the AGV motion control information and the device operation information based on the AGV state data from the AGV controller and the device state. The AGV motion control information is used to make the AGV reach a desired location and perform a desired action, and the device operation information is used to make the virtual device reach a desired location and perform a desired action. The scheduling manager continues to send a device state request to the emulator. When the received device state of the virtual device is in a desired state, the scheduling manager sends the AGV control information to the AGV controller again to enable the virtual AGV in the emulation environment to interact with the virtual device.

After receiving the AGV control information, the AGV controller generates motor control information of the virtual AGV based on the AGV control information and the current position and the current orientation of the virtual AGV, or further converts the motor control information into position control information, and sends the position control information to the emulator.

Next, the method 100 proceeds to step 104 in which motion of the virtual AGV and the virtual device in the emulation environment is controlled based on the AGV motion control information and the device operation information respectively. After receiving the AGV motion control information and the device operation information, the emulator, on the one hand, controls, based on an AGV target position and an execution action included in the AGV motion control information, the virtual AGV to move to the target position and perform the corresponding action, and on the other hand, controls, based on an execution action included in the device operation information, the virtual device to move to the target position and perform the corresponding action. The virtual AGV can interact with the virtual device in the emulation environment by controlling motion and actions of the virtual AGV and the virtual device respectively. For example, the elevator unloads materials to the virtual AGV, and the virtual AGV passes through the automated door, and takes the lift to the conveyor belt to unload the materials, and so on.

In some embodiments, controlling motion of the virtual AGV and the virtual device in the emulation environment based on the AGV motion control information and the device operation information respectively further includes (not shown in FIG. 1): determining next positions of moving components of the virtual AGV based on the AGV motion control information, a kinematic model of the virtual AGV, and current positions of the moving components of the virtual AGV; and determining next positions of moving components of the virtual device based on the device operation information, a kinematic model of the virtual device, and current positions of the moving components of the virtual device, where the kinematic models of the virtual AGV and the virtual device include motion relationships and motion parameters of the moving components of the virtual AGV and the virtual device.

As mentioned above, the kinematic model of the AGV and the kinematic model of the virtual device define the motion relationships and the motion parameters of the moving components of the AGV and the virtual device respectively. The AGV motion control information may be motor control information or position control information. The motor control information may include a rotation direction and a rotation angle of a motor of the virtual AGV, and the position control information may include an entire motion direction, a rotation direction, and a rotation angle of the virtual AGV and a travel speed of the virtual AGV. The next positions of the moving components of the AGV are calculated based on the AGV motion control information, the kinematic model of the AGV, and the current positions of the moving components of the AGV. The device operation information includes a target position and an execution action of the virtual device. The device operation information is converted into the target position of the virtual device and control information of joints between the moving components of the virtual device. The next positions of the moving components of the virtual device are calculated according to the target position of the virtual device and the converted control information of joints, the kinematic model of the virtual device, and the current positions of the moving components of the virtual device. The next positions of the moving components of the virtual AGV and the moving components of the virtual device obtained by calculation may be provided for a collision detection unit for collision detection and a 3D rendering unit for display of a 3D image (to be described below).

Motion of a virtual AGV and a virtual device in an emulation environment is controlled based on AGV motion control information and device operation information from an actual AGV system respectively to enable the virtual AGV and the virtual device in the emulation environment to be controlled by an actual control signal without relying on manual input, and thus an emulation result is closer to a situation in an actual factory.

In some embodiments, the method 100 further includes (not shown in FIG. 1): determining whether the virtual AGV collides with or is excessively close to a virtual device and/or an environmental object around the virtual AGV. In the actual factory, an AGV, when performing a transport task, may collide with a virtual device, a static or dynamic object, or other AGVs around the AGV, which indicates a problem with deployment of the AGV. Therefore, collision detection may be performed in the emulation environment.

In some embodiments, determining whether the virtual AGV collides with or is excessively close to a virtual device and/or an environmental object around the virtual AGV further includes: determining a distance between the virtual AGV and the virtual device and/or the environmental object around the virtual AGV based on a 3D model of the virtual AGV and a 3D model of the virtual device and/or the environmental object around the virtual AGV; and determining, according to the determined distance, whether the virtual AGV collides with or is excessively close to the virtual device and/or the environmental object around the virtual AGV, where the 3D model of the virtual AGV and the 3D model of the virtual device and/or the environmental object around the virtual AGV include contour data of virtual AGV and the virtual device and/or the environmental object around the virtual AGV respectively. A distance between the AGV and the virtual device and/or the environmental object can be obtained by performing calculation using contour data defined by the 3D model of the virtual AGV, contour data defined by the 3D model of the virtual device and/or the environmental object around the virtual AGV, and a current position of the virtual device and/or the environmental object around the virtual AGV. When the distance is less than or equal to zero, it indicates the AGV has invaded a virtual device and/or an environmental object. When the distance is less than a threshold value, it indicates that the AGV is excessively close to the virtual device or and/or the environmental object.

Through collision detection on the virtual AGV and a virtual device and/or an environmental object around the virtual AGV, a collision event in an actual factory environment can be emulated to help a user of the simulator to adjust deployment of the AGV.

In some embodiments, the method 100 further includes (not shown in FIG. 1): displaying, according to 3D models of all virtual AGVs, virtual devices, and environmental objects in the emulation environment, 3D images of all the virtual AGVs, virtual devices, and environmental objects through a display interface. The 3D images of all the virtual AGVs, virtual devices, and environmental objects can be displayed on the display interface through a 3D rendering technology by using the 3D models and current positions of all the virtual AGVs, virtual devices, and environmental objects, so that motion and/or operations of the AGV and the automated devices similar to those in an actual factory can be observed on the display interface. In addition to the 3D models, a result of the collision detection may also be displayed on the display interface to highlight the AGV colliding with and/or excessively close to the virtual device and/or the environmental object around the AGV, and so on.

A visualization effect is achieved by displaying the 3D images of the virtual AGV, the virtual device, and the environmental object, which can help a user of the emulator to directly observe an interaction process and entire emulation between the virtual AGV and the virtual device, thus making debugging and deployment of the AGV easier.

Virtual sensor data can be generated in the emulation environment by emulating a sensor of the AGV in the emulator, so that an actual AGV controller obtains the sensor data from a virtual world rather than a real world. In addition, a virtual device state can be generated in the emulation environment by emulating an automated device in the emulator, so that the scheduling manager controls a virtual automated device and the virtual AGV in the emulation environment, thus achieving emulation of interaction between the AGV and the automated device and then validating and debugging the interaction. After emulation is run, by viewing AGV task execution time, AGV waiting time, and other indicators of the scheduling manager, transport operation time, order and congestion can also be checked, and then a routing and scheduling algorithm is optimized. Therefore, through virtual emulation and debugging, time and efforts spent by a deployment engineer in deployment and debugging are reduced and factory downtime is decreased according to the method of the present disclosure. Besides, with the method of the present disclosure, an entire AGV system (including an AGV controller and a scheduling manager) and an AGV sensor, not just a part of the AGV system, can be validated.

A method for emulating an AGV system is described below with reference to a specific embodiment.

FIG. 2 illustrates an emulation system for implementing the emulation method in FIG. 1 according to an embodiment of the present disclosure. In FIG. 2, an emulation system 200 includes an emulator 21, an AGV system 22, and an order generator 23. The AGV system 22 and the order generator 23 are both actual systems in a factory. The order generator 22 may be an external system running in the factory, for example, a warehouse management system (WMS) a manufacturing execution system (MES), or other systems that can send transport orders to the AGV system. Content of the transport order may include, for example, a transport starting place, a transport destination, a type and a quantity of a material, a time requirement, etc. The AGV system 22 includes an adapter 221, a scheduling manager 222, and a plurality of AGV controllers. The adapter 221 receives a transport order from the order generator 22, and converts the transport order into a plurality of AGV transport tasks and sends the AGV transport tasks to the scheduling manager 222 according to types of materials transported by different AGVs and maximum carrying capacities. Each of the AGV transport tasks may include a transport starting place, a transport destination, and a required AGV number. Besides, the adapter 221 may also prioritize the AGV transport tasks according to the time requirement in the transport order.

In an actual factory, the scheduling manager 222 schedules and routes, according to the AGV transport tasks from the adapter 221, AGV state data from the plurality of AGV controllers 223, and a device state from a device server, all AGVs controlled by the plurality of AGV controllers 223 based on a preset routing and scheduling rule. The scheduling manager 222 sends device control information to the device server, and sends AGV control information to the AGV controllers 223 to accordingly control automated devices and the AGVs respectively, so that transport tasks are allocated to the AGVs and in a process of performing the transport tasks by the AGVs, the AGVs implement interaction with the related automated devices. The device server may be a warehouse control system (WCS), a supervisory control and data acquisition system (SCADA), a distributed control system (DCS), or other systems controlling the automated devices in the factory. In the emulation system 200, the automated devices are virtualized in the emulator 21, without the use of any actual automated device. Therefore, the device state received by the scheduling manager 222 is from a virtual device in the emulator 21, and the generated device control information is also sent to the emulator 21 to control the virtual device.

In the actual factory, the AGV controller 222 calculates a current position and a current orientation of an AGV controlled by the AGV controller according to the received sensor data (e.g., scanning data from a lidar, image data from a camera, a response result from a trajectory tracker, and so on), that is, positions the AGV controlled by the AGV controller. The AGV controller 223 further sends the current position and the current orientation of the AGV obtained by calculation, a transport task being performed by the AGV, a target position, and speed parameters (e.g., an acceleration, a maximum speed, a motor speed, etc.), power and elapsed runtime of the AGV, and other information as state data of the AGV to the scheduling manager. In this embodiment, in response to a request from the scheduling manager 222, the AGV controller 223 periodically sends state data of the AGV to the scheduling manager 222, so that the scheduling manager 222 can obtain the state data of the AGV in real time. The AGV controller 223 further generates motor control information according to AGV control information and the current position and the current orientation of the AGV received from the scheduling manager 222, for controlling motion of the AGV. In the emulation system 200, the AGVs are virtualized in the emulator 21, without the use of any actual AGV. Therefore, the sensor data received by the AGV controller 223 is from a virtual AGV in the emulator 21, and the motor control information is sent to the emulator 21 to control the virtual AGV. When the kinematic model of the virtual AGV does not include a motor, the AGV controller may further convert the motor control information into position control information and send the position control information to the virtual AGV 212. In this embodiment, the AGV controller 223 may be an actual hardware controller, or an analog controller running on a PC or an embedded system.

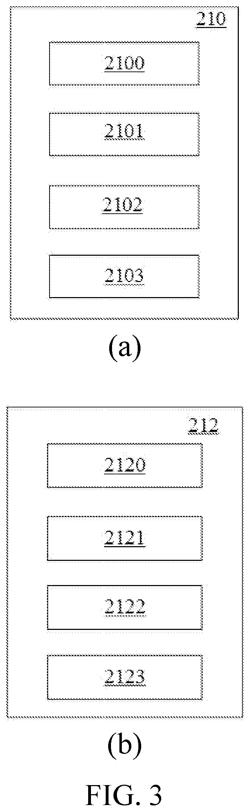

Referring to FIG. 2 and FIG. 3, the emulator 21 includes several virtual devices such as virtual devices 210 and 210', a virtual device server 211, several virtual AGVs such as virtual AGVs 212 and 212', a device signal transmission unit 213, an AGV connection unit 214, a motion control unit 215, a collision detection unit 216, and a 3D rendering unit 217. Quantities and types of the virtual devices and the virtual AGVs in the emulator 21 may vary according to different factory environments. It should be noted that although not shown in FIG. 2, the emulator 21 further includes 3D models and/or kinematic models of other environmental objects, for example, static objects such as enclosures and boxes and dynamic objects such as workers. Descriptions are provided below based on one virtual device 210 and one virtual AGV 212. It should be noted that other virtual devices and virtual AGVs have the same or similar components as the virtual device 210 and the virtual AGV 212.

As shown in FIG. 3(a), the virtual device 210 includes a 3D model 2100, a kinematic model 2101, a sensor model 2102, and a state determining unit 2103. The 3D model 2100 describes a contour of the virtual device, i.e., a shape and a size. The kinematic model 2101 describes motion relationships and motion parameters of moving components of the virtual device, such as connection relationships, motion types, motion directions, and motion limits of the moving components. The sensor model 2102 is used to detect relative motion between the moving components, which may include a position (for example, at joints of the moving components) and parameters of a virtual sensor. The state determining unit 2103 is configured to obtain state data of the virtual device based on the sensor model 2102, and determine a device state of the virtual device according to the state data. The state determining unit 2103 periodically determines the device state of the virtual device 210, and saves the device state in the virtual device server 211. Besides, the state determining unit 2103 further converts device operation information from the scheduling manager 222 into a target position of the virtual device and joint control information for joints between the moving components of the virtual device.

The device signal transmission unit 213 is configured to implement communication between the scheduling manager 222 and the virtual device 210, which may be defined according to an actual interface of the scheduling manager 222. In this embodiment, the device signal transmission unit 213 sends a current device state of a corresponding virtual device on the device server 211 to the scheduling manager 222 in response to a request from the scheduling manager 222. Besides, the device signal transmission unit 213 further receives device operation information from the scheduling manager 222, and sends the device operation information to the state determining unit 2103.

As shown in FIG. 3(b), the virtual AGV 212 includes a 3D model 2120, a kinematic model 2121, a sensor model 2122, and a sensor detection unit 2123. The 3D model 2120 describes a contour of an AGV body, i.e., a shape and a size. The kinematic model 2121 describes motion relations and motion parameters of moving components of the AGV body, such as connection relationships, motion types, motion directions, and motion limits of the moving components. The sensor model 2123 describes a position of an AGV sensor relative to the AGV body and sensor parameters. The sensor detection unit 2123 obtains sensor data based on the sensor model of the virtual AGV and a 3D model of a virtual device and/or an environmental object around the virtual AGV.

The AGV connection unit 214 is configured for communication between the AGV controller 223 and the virtual AGV 212, which may be defined according to an actual interface of the AGV controller 223. In this embodiment, the AGV connection unit 214 periodically sends the sensor data obtained by the virtual AGV 212 to the AGV controller, so that the AGV controller 223 can position the virtual AGV 212 in real time.

The motion control unit 215 receives the motor control information or the position control information and the device operation information through the device signal transmission unit 213 and the AGV connection unit 214 respectively. The motion control unit 215 calculates next positions of moving components of the virtual AGV 212 based on the motor control information or the position control information, motion relationships and motion parameters defined in the kinematic model 2121 of the virtual AGV, and current positions of the moving components of the virtual AGV 212. Besides, the motion control unit 215 further determines next positions of moving components of the virtual device 210 based on the device operation information, the kinematic model 2101 of the virtual device 210, and current positions of the moving components of the virtual device 210. The motion control unit 215 provides the next positions of moving components of the virtual AGV 212 and the virtual device 210 obtained by calculation to the collision detection unit 216 for collision detection, and the 3D rendering unit 217 is configured to display motion of the virtual AGV 212 and the virtual device 210 through a display interface.

The collision detection unit 216 calculates a distance between the virtual AGV and a virtual device and/or an environmental object around the virtual AGV based on contour data defined by the 3D model 2120 of the virtual AGV and a 3D model of the virtual device and/or the environmental object (not shown in FIG. 2) around the virtual AGV 212 and positions of the virtual AGV, the virtual device and/or the environmental object. When the distance is less than or equal to zero, it indicates the virtual AGV 210 collides with the virtual device and/or the environmental object around the virtual AGV. When the distance is less than a threshold value, it indicates that the virtual AGV 210 is excessively close to the virtual device and/or the environmental object around the virtual AGV. Afterwards, the collision detection unit 216 displays a detection report through the display interface, for a user to view.

The 3D rendering unit 217 displays, according to 3D models of all virtual AGVs, virtual devices, and environmental objects in the emulation environment, 3D images of all the virtual AGVs, virtual devices, and environmental objects through a display interface. Through the 3D rendering unit 217, an entire emulation environment and an entire motion process of all the virtual AGVs and virtual devices in the emulation process can be displayed through the display interface.

In the embodiment, the interaction between the AGV and the automated device can be emulated, then the interaction can be validated and debugged, and transport operation time, order, and congestion can be checked, thus optimizing the routing and scheduling algorithm. Therefore, according to the embodiment, time and efforts spent by a deployment engineer on deployment and debugging, and factory downtime is decreased. Besides, according to the embodiment, an entire AGV system and an AGV sensor, not just a part of the AGV system, can be validated.

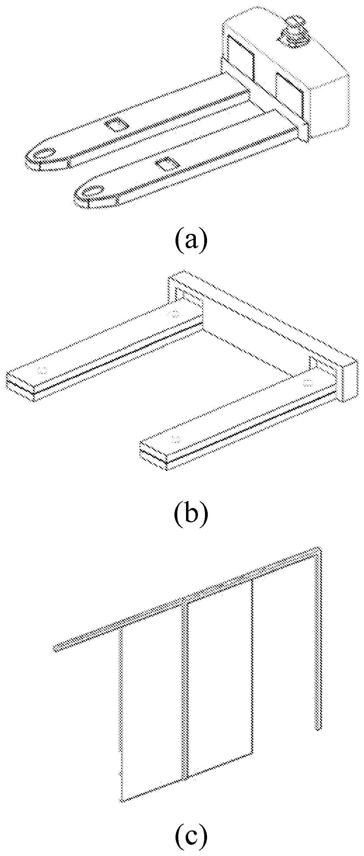

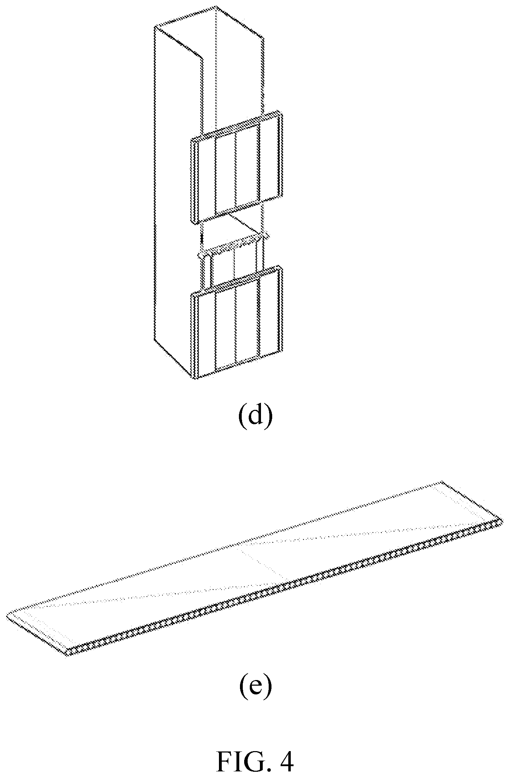

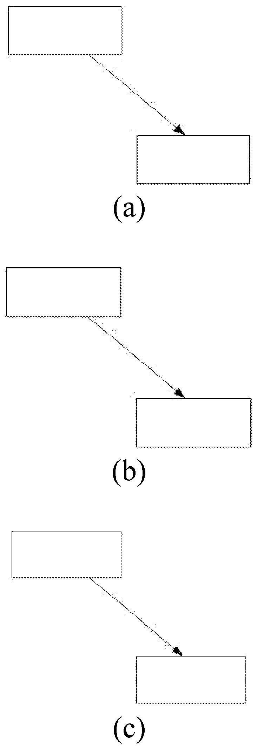

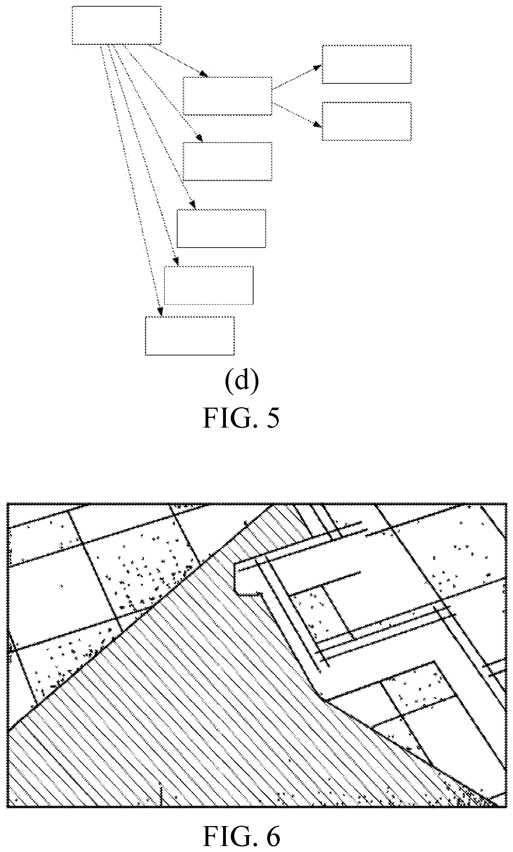

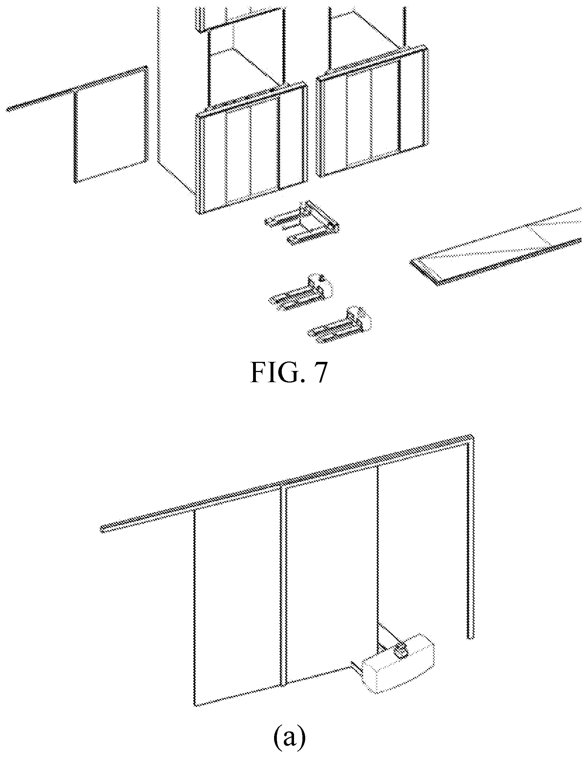

FIG. 4(a) to FIG. 4(e) illustrate 3D models of one AGV and automated devices interacting with the AGV in the embodiment of FIG. 2. FIG. 5(a) to FIG. 5(d) illustrate kinematic models of the AGV and the automated devices interacting with the AGV in FIG. 4. FIG. 6 is a schematic diagram of a virtual lidar of a virtual AGV in FIG. 4(a) displayed through a display interface. FIG. 7 illustrates a schematic emulation environment according to the embodiment of FIG. 2 displayed through a display interface. In the embodiments of FIG. 4 to FIG. 7, the scheduling manager 222 schedules the AGV to load materials from an elevator in a second-floor workshop and conveys the materials to a conveyor belt in a first-floor workshop. In a transport path, the AGV passes through an automated door and takes a lift to the first floor. Therefore, the automated devices interacting with the AGV involve an elevator, an automated door, a lift, and a conveyor belt.

As shown in FIG. 4(a) to FIG. 4(e), shapes and sizes of the AGV, the elevator, the automated door, the lift, and the conveyor belt are defined in the 3D model respectively. In the kinematic model of FIG. 5(a), various moving components of the AGV, i.e., a base and a lifting platform, are illustrated, a motion type of the two moving components, the base and the lifting platform, is defined as parallel motion, a motion direction is defined as up and down, and a maximum range of motion and other motion parameters are defined. Similarly, in the kinematic model of FIG. 5(b), various moving components of the elevator, i.e., a base and a lifting platform, are illustrated; in the kinematic model of FIG. 5(c), various moving components of the automated door, i.e., a door frame and a door leaf, are illustrated; in the kinematic model of FIG. 5(d), various moving components of the lift, i.e., a lift shaft, a car body, two door leafs of a car, two door leafs on the second floor, and two door leafs on the first floor, are illustrated. Since the conveyor belt moves as a whole, a kinematic model may not be built for the conveyor belt.

In this embodiment, a lidar is used as a sensor of the AGV. Therefore, the sensor model of the virtual AGV includes a position of the lidar relative to the AGV body, and scanning wiring harnesses (e.g., 12/24/48 bundles), a scanning angle (e.g., 120°/180°/360°), and a wiring-harness effective distance (e.g., 1/2/5 m) of the lidar. In this way, when the virtual AGV obtains sensor data in an emulation environment, the sensor data can be obtained according to the position of the lidar and the parameters of the lidar defined in the sensor model. In this embodiment, the sensor data is a set of data corresponding to a quantity of the wiring harness of the lidar and having a value less than or equal to the wiring-harness effective distance, for example, [*v₁,v₂,v₃, ... vᵢ*]*,* where i is a wiring harness of the lidar, and v is, for each wiring harness, a distance between the position of the lidar and a virtual device and/or an environmental object (when the virtual device and/or the environmental object exists within an effective distance of the wiring harness) or an effective distance of the wiring harness (when no virtual device and/or environmental object exists within the effective distance of the wiring harness). FIG. 6 is a schematic diagram of a virtual lidar of a virtual AGV in FIG. 4(a) displayed through a display interface.

In this embodiment, a sensor model is built for each of the elevator, the automated door, and the lift, so as to dispose a virtual sensor at joints of the moving components to detect relative motion between the moving components. The position of the virtual sensor of the elevator is located at the joint between the base and the lifting platform, and the relative motion of the base and the lifting platform can be detected through changes of a coordinate position of the lifting platform. Similarly, the position of the virtual sensor of the automated door is located at the joint between the door frame and the door leaf. There are two virtual sensors in the lift, one is a virtual height sensor on the car or on the ground, and the other one is a position sensor at the joint between the door frame and the door leaf of the car.

In this embodiment, when the AGV system 22 is emulated, the virtual AGV periodically obtains sensor data based on a lidar model and sends the sensor data to the AGV controller 223. The AGV controller 223 positions a current position of the virtual AGV, and in response to a request from the scheduling manager 222, periodically sends state data of the virtual AGV to the scheduling manager 222. A virtual elevator, a virtual automated door, a virtual lift, and a virtual conveyor belt periodically determine a state of a current virtual device, and save the state in the virtual device server 211. The scheduling manager 222 determines, according to the current position of the virtual AGV, a virtual device to interact with the virtual AGV, and sends a device state request for the virtual device to the virtual device server 211. According to a current state of the virtual device returned by the virtual device server 211, the scheduling manager 222 generates device operation information and sends the device operation information to the virtual device to control the virtual device to reach a desired device state (e.g., enable the virtual lift to reach a destination floor and open), and generates AGV control information and sends the AGV control information to the AGV controller 223 to control an action (e.g., wait in place) of the virtual AGV. When the virtual device to interact with the virtual AGV is in the desired device state, the scheduling manager 222 sends the AGV control information to the AGV controller 223 to enable the AGV controller 223 to control motion (e.g., enter the lift) of the virtual AGV.

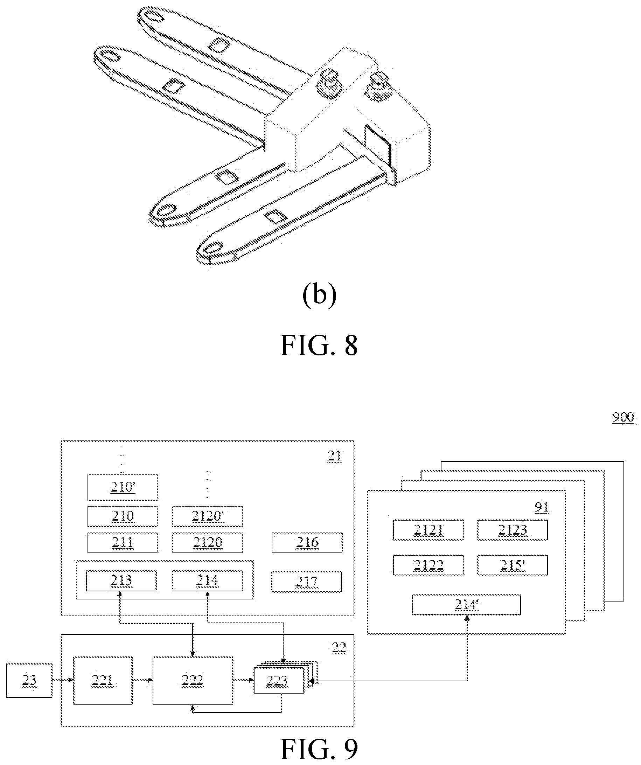

Meanwhile, during the motion of the virtual AGV, the collision detection unit 216 determines whether the virtual AGV collides with or is excessively close to a virtual device and/or an environmental object around the virtual AGV, and displays a collision detection result through a display interface. The collision detection result includes time, a moving component name 1, a moving component name 2, a distance, and a state (collision/being excessively close). FIG. 7 illustrates a schematic emulation environment according to the embodiment of FIG. 2 displayed through a display interface. As shown in FIG. 7, an AGV system and interaction between an AGV and an automated device can be emulated close to an actual factory. FIG. 8(a) to FIG. 8(b) are schematic diagrams of collision of a virtual AGV with a virtual device and an environmental object in FIG. 4(a) displayed through a display interface respectively.

FIG. 9 illustrates another emulation system for implementing the emulation method in FIG. 1 according to an embodiment of the present disclosure. An emulation system 900 includes a main emulator 21 and a plurality of auxiliary emulators 91. The main emulator 21 and the auxiliary emulators 91 may run in different hardware devices to increase an emulation speed. In this embodiment, a 3D model 2120 or 2120' of each AGV is retained in the main emulator 21, and a kinematic model (e.g., a kinematic model 2121), a sensor model (e.g., a sensor detection model 2122), and a sensor detection unit (e.g., a sensor detection unit 2123) of each AGV are all deployed in the auxiliary emulators 91. A quantity of the auxiliary emulators may be determined as required. For example, one auxiliary emulator 91 may be disposed for each AGV, or one auxiliary emulator 91 may be disposed for a plurality of AGVs.

In the auxiliary emulators 91, in addition to the kinematic model, the sensor model, and the sensor detection unit of the AGV, each of the auxiliary emulators 91 further includes a motion control unit 215' and an AGV connection unit 214' specific to the virtual AGV. The motion control unit 215' is configured to calculate next positions of moving components of the AGV according to the AGV control information, the kinematic model 2121 of the virtual AGV, and current positions of the moving components of the AGV. The AGV connection unit 214' is configured to implement communication between the virtual AGV in the auxiliary emulator 91 and the AGV controller 223. Other components or units in FIG. 9 are the same as those in FIG. 2, and descriptions thereof are omitted herein.

During emulation, the sensor detection unit 2123 in the auxiliary emulator 91 sends sensor data of the virtual AGV to the AGV controller 223 through the AGV connection unit 214', and the AGV controller 223 positions the virtual AGV and sends, through the AGV connection unit 214', AGV motion control information to the motion control unit 215'. The motion control unit 215' determines the next positions of the moving components of the AGV and sends, through the AGV connection unit 214', the next positions to the AGV controller 223. The AGV controller 223 sends the next positions of the moving components to the main emulator 21 again through the AGV connection unit 214, so as to perform collision detection and display 3D images through the collision detection unit 216 and the 3D rendering unit 217.

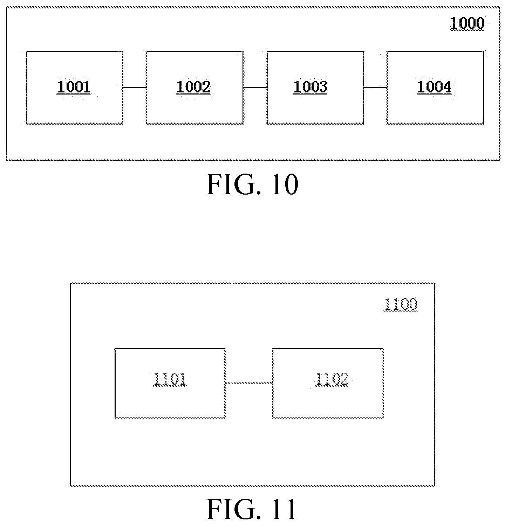

FIG. 10 illustrates an apparatus for emulating an AGV system according to an embodiment of the present disclosure. Referring to FIG. 10, an apparatus 1000 includes a sensor detection unit 1001, a state determining unit 1002, a data communications unit 1003, and a motion control unit 1004. The sensor detection unit 1001 is configured to obtain sensor data of a virtual AGV in an emulation environment. The state determining unit 1002 is configured to determine a device state of a virtual device interacting with the virtual AGV in the emulation environment. The data communications unit 1003 is configured to send the sensor data and the device state to the AGV system, and receive AGV motion control information and device operation information from the AGV system, where the AGV motion control information and the device operation information are generated by the AGV system based on the sensor data and the device state. The motion control unit 1004 is configured to control motion of the virtual AGV and the virtual device in the emulation environment based on the AGV motion control information and the device operation information respectively. The units in FIG. 9 may be implemented by software, hardware (e.g., an integrated circuit, a FPGA, or the like) or a combination of software and hardware.

In some embodiments, the sensor detection unit 1001 is further configured to: obtain the sensor data based on a sensor model of the virtual AGV, the sensor model of the virtual AGV including a position and parameters of a virtual sensor of the virtual AGV.

In some embodiments, the state determining unit 1002 is further configured to: obtain state data of the virtual device based on a sensor model of the virtual device, the state data representing relative motion between moving components of the virtual device, where the sensor model of the virtual device includes a position and parameters of a virtual sensor of the virtual device; and determine the device state of the virtual device according to the state data.

In some embodiments, the motion control unit 1004 is further configured to: determine next positions of moving components of the virtual AGV based on the AGV motion control information, a kinematic model of the virtual AGV, and current positions of the moving components of the virtual AGV; and determine next positions of moving components of the virtual device based on the device operation information, a kinematic model of the virtual device, and current positions of the moving components of the virtual device, where the kinematic models of the virtual AGV and the virtual device include motion relationships and motion parameters of the moving components of the virtual AGV and the virtual device.

In some embodiments, the apparatus 1000 further includes a collision detection unit (not shown in FIG. 9), configured to determine whether the virtual AGV collides with or is excessively close to a virtual device and/or an environmental object around the virtual AGV.

In some embodiments, the collision detection unit is further configured to: determine a distance between the virtual AGV and the virtual device and/or the environmental object around the virtual AGV based on a 3D model of the virtual AGV and a 3D model of the virtual device and/or the environmental object around the virtual AGV; and determine, according to the determined distance, whether the virtual AGV collides with or is excessively close to the virtual device and/or the environmental object around the virtual AGV, where the 3D model of the virtual AGV and the 3D model of the virtual device and/or the environmental object around the virtual AGV include contour data of virtual AGV and the virtual device and/or the environmental object around the virtual AGV respectively.

In some embodiments, the apparatus 1000 further includes a 3D rendering unit (not shown in FIG. 9), configured to display, according to 3D models of all virtual AGVs, virtual devices, and environmental objects in the emulation environment, 3D images of all the virtual AGVs, virtual devices, and environmental objects through a display interface.

FIG. 11 is a block diagram of a computing device for emulating an AGV system according to an embodiment of the present disclosure. It can be seen from FIG. 11 that a computing device 1100 for emulating an AGV system includes a processor 1101 and a memory 1102 coupled to the processor 1101. The memory 1102 is configured to store a computer-executable instruction, the computer-executable instruction, when executed, causing the processor 1101 to perform the methods in the above embodiment.

In addition, alternatively, the method can be implemented through a computer-readable storage medium. The computer-readable storage medium stores a computer-executable program instruction that is used to perform the method according to various embodiments of the present disclosure. The computer-readable storage medium may be an actual device that can retain and store an instruction used by an instruction-executing device. The computer-readable storage medium may be, for example, but is not limited to, an electrical storage device, a magnetic storage device, an optical storage device, an electromagnetic storage device, a semiconductor storage device, or any appropriate combination of the above. In a more specific example (a non-exhaustive list), the computer-readable storage medium includes a portable computer disk, a hard disk, a random access memory (RAM), a read-only memory (ROM), an erasable programmable read-only memory (EPROM or flash memory), a static random access memory (SRAM), a portable compact disk read-only memory (CD-ROM), a digital versatile disk (DVD), a memory stick, a floppy disk, a mechanical coding device such as a punched card or protrusion in a groove in which instructions are stored, and any appropriate combination of the above. The computer-readable storage medium as used here is not explained as a transient signal itself, such as a radio wave or other electromagnetic waves propagated freely, an electromagnetic wave propagated through a waveguide or other transmission media (e.g., a light pulse propagated through an optical fiber cable), or an electrical signal transmitted over a wire.

Therefore, in another embodiment, a computer-readable storage medium is proposed in the present disclosure. The computer-readable storage medium stores a computer-executable instruction that is used to perform the method according to various embodiments of the present disclosure.

In another embodiment, a computer program product is proposed in the present disclosure. The computer program product is tangibly stored in a computer-readable storage medium, and includes a computer-executable instruction that, when executed, causes at least one processor to perform the method according to various embodiments of the present disclosure.

In general, various exemplary embodiments of the present disclosure can be implemented in hardware or a dedicated circuit, software, firmware, logic, or any combination thereof. Some aspects can be implemented in hardware, while other aspects can be implemented in firmware or software executable by a controller, a microprocessor, or other computing devices. When various aspects of the embodiments of the present disclosure are illustrated or described as block diagrams, flowcharts, or represented by some other graphs, it should be undersexcessivelyd that the blocks, apparatuses, systems, technologies, or methods described herein can be implemented, as non-restrictive examples, in hardware, software, firmware, a dedicated circuit or logic, general-purpose hardware or a controller or other computing devices, or some combinations thereof.

The computer-readable program instruction or computer program product for implementing various embodiments of the present disclosure can also be stored in a cloud, and when invocation is necessary, a user can access the computer-readable program instruction stored in the cloud and used to implement an embodiment of the present disclosure through a mobile Internet, a fixed network, or other networks, thus implementing the technical solutions disclosed according to various embodiments of the present disclosure.

The embodiments of the present disclosure are intended to cover various modifications included within the scope of the appended claims.

## Claims

1. A method for emulating an automated guided vehicle (AGV) system, comprising:
obtaining sensor data of a virtual AGV in an emulation environment; wherein said obtaining further comprises obtaining sensor data based on a sensor model of the virtual AGV, the sensor model of the virtual AGV comprising a position and parameters of a virtual sensor of the virtual AGV;
determining a device state of a virtual device interacting with the virtual AGV in the emulation environment; further comprising obtaining state data of the virtual device based on a sensor model of the virtual device, the state data representing relative motion between moving components of the virtual device, and the sensor model of the virtual device comprising a position and parameters of a virtual sensor of the virtual device; and determining the device state of the virtual device according to the state data;
sending the sensor data and the device state to the AGV system, and receiving AGV motion control information and device operation information from the AGV system, wherein the AGV motion control information and the device operation information are generated by the AGV system based on the sensor data and the device state; and
controlling motion of the virtual AGV and the virtual device in the emulation environment based on the AGV motion control information and the device operation information respectively; wherein said motion controlling further comprises determining next positions of moving components of the virtual AGV based on the AGV motion control information, a kinematic model of the virtual AGV, and current positions of the moving components of the virtual AGV; and determining next positions of moving components of the virtual device based on the device operation information, a kinematic model of the virtual device, and current positions of the moving components of the virtual device, wherein the kinematic models of the virtual AGV and the virtual device comprise motion relationships and motion parameters of the moving components of the virtual AGV and the virtual device respectively.

2. The method according to claim 1, further comprising: determining whether the virtual AGV collides with or is excessively close to a virtual device and/or an environmental object around the virtual AGV.

3. The method according to claim 2, wherein the determining whether the virtual AGV collides with or is excessively close to a virtual device and/or an environmental object around the virtual AGV further comprises:
determining a distance between the virtual AGV and the virtual device and/or the environmental object around the virtual AGV based on a 3D model of the virtual AGV and a 3D model of the virtual device and/or the environmental object around the virtual AGV; and
determining, according to the determined distance, whether the virtual AGV collides with or is excessively close to the virtual device and/or the environmental object around the virtual AGV, wherein
the 3D model of the virtual AGV and the 3D model of the virtual device and/or the environmental object around the virtual AGV comprise contour data of virtual AGV and the virtual device and/or the environmental object around the virtual AGV respectively.

4. The method according to claim 1, further comprising:
displaying, according to 3D models of all virtual AGVs, virtual devices, and environmental objects in the emulation environment, 3D images of all the virtual AGVs, virtual devices, and environmental objects through a display interface.

5. An apparatus for emulating an automated guided vehicle (AGV) system, comprising:
a sensor detection unit, configured to obtain sensor data of a virtual AGV in an emulation environment; wherein said sensor detection unit is further configured to obtain the sensor data based on a sensor model of the virtual AGV, the sensor model of the virtual AGV comprising a position and parameters of a virtual sensor of the virtual AGV;
a state determining unit, configured to determine a device state of a virtual device interacting with the virtual AGV in the emulation environment; further configured to obtain state data of the virtual device based on a sensor model of the virtual device, the state data representing relative motion between moving components of the virtual device, and the sensor model of the virtual device comprising a position and parameters of a virtual sensor of the virtual device;
a data communications unit, configured to send the sensor data and the device state to the AGV system, and receive AGV motion control information and device operation information from the AGV system, wherein the AGV motion control information and the device operation information are generated by the AGV system based on the sensor data and the device state; and
a motion control unit, configured to control motion of the virtual AGV and the virtual device in the emulation environment based on the AGV motion control information and the device operation information respectively; wherein said control unit is further configured to determine next positions of moving components of the virtual AGV based on the AGV motion control information, a kinematic model of the virtual AGV, and current positions of the moving components of the virtual AGV; and to determine next positions of moving components of the virtual device based on the device operation information, a kinematic model of the virtual device, and current positions of the moving components of the virtual device, wherein the kinematic models of the virtual AGV and the virtual device comprise motion relationships and motion parameters of the moving components of the virtual AGV and the virtual device respectively.

6. The apparatus according to claim 5, further comprising a collision detection unit, configured to determine whether the virtual AGV collides with or is excessively close to a virtual device and/or an environmental object around the virtual AGV.

7. The apparatus according to claim 6, wherein the collision detection unit is further configured to:
determine a distance between the virtual AGV and the virtual device and/or the environmental object around the virtual AGV based on a 3D model of the virtual AGV and a 3D model of the virtual device and/or the environmental object around the virtual AGV; and
determine, according to the determined distance, whether the virtual AGV collides with or is excessively close to the virtual device and/or the environmental object around the virtual AGV, wherein
the 3D model of the virtual AGV and the 3D model of the virtual device and/or the environmental object around the virtual AGV comprise contour data of virtual AGV and the virtual device and/or the environmental object around the virtual AGV respectively.

8. The apparatus according to claim 5, further comprising a 3D rendering unit, configured to display, according to 3D models of all virtual AGVs, virtual devices, and environmental objects in the emulation environment, 3D images of all the virtual AGVs, virtual devices, and environmental objects through a display interface.

9. A computing device, comprising:
a processor; and
a memory, configured to store a computer-executable instruction, the computer executable instruction, when executed, causing the processor to perform the method according to any one of claims 1 to 4.

10. A computer-readable storage medium, comprising a computer-executable instruction stored therein, the computer-executable instruction being used to perform the method according to any one of claims 1 to 4.

11. A computer program product, tangibly stored in a computer-readable storage medium and comprising a computer-executable instruction, the computer-executable instruction, when executed, causing at least one processor to perform the method according to any one of claims 1 to 4.

## Patentansprüche

1. Verfahren zum Emulieren eines Systems mit fahrerlosen Transportfahrzeugen (FTF), das Folgendes umfasst:
Erfassen von Sensordaten für ein virtuelles FTF in einer Emulationsumgebung, wobei das Erfassen ferner ein Erfassen von Sensordaten auf der Grundlage eines Sensormodells von dem virtuellen FTF umfasst, wobei das Sensormodell von dem virtuellen FTF eine Position und Parameter eines virtuellen Sensors des virtuellen FTF umfasst,
Ermitteln eines Gerätezustands eines virtuellen Geräts, das mit dem virtuellen FTF in der Emulationsumgebung interagiert, ferner mit dem Erfassen von Zustandsdaten von dem virtuellen Gerät auf der Grundlage eines Sensormodells von dem virtuellen Gerät, wobei die Zustandsdaten eine Relativbewegung zwischen sich bewegenden Komponenten des virtuellen Geräts repräsentieren und das Sensormodell von dem virtuellen Gerät eine Position und Parameter eines virtuellen Sensors des virtuellen Geräts umfasst, und mit dem Ermitteln des Gerätezustands des virtuellen Geräts entsprechend den Zustandsdaten,
Senden der Sensordaten und des Gerätezustands zu dem FTF-System und Empfangen von FTF-Bewegungssteuerungsinformationen und Gerätebetriebsinformationen aus dem FTF-System, wobei die FTF-Bewegungssteuerungsinformationen und die Gerätebetriebsinformationen auf der Grundlage der Sensordaten und des Gerätezustands von dem FTF-System generiert werden, und
Steuern einer Bewegung des virtuellen FTF und des virtuellen Geräts in der Emulationsumgebung auf der Grundlage der FTF-Bewegungssteuerungsinformationen beziehungsweise der Gerätebetriebsinformationen, wobei die Bewegungssteuerung ferner ein Ermitteln von nächsten Positionen sich bewegender Komponenten des virtuellen FTF auf der Grundlage der FTF-Bewegungssteuerungsinformationen, eines kinematischen Modells von dem virtuellen FTF und aktueller Positionen der sich bewegenden Komponenten des virtuellen FTF umfasst, und Ermitteln von nächsten Positionen sich bewegender Komponenten des virtuellen Geräts auf der Grundlage der Gerätebetriebsinformationen, eines kinematischen Modells von dem virtuellen Gerät und aktueller Positionen der sich bewegenden Komponenten des virtuellen Geräts, wobei die kinematischen Modelle von dem virtuellen FTF und dem virtuellen Gerät Bewegungsbeziehungen und Bewegungsparameter der sich bewegenden Komponenten des virtuellen FTF beziehungsweise des virtuellen Geräts umfassen.

2. Verfahren nach Anspruch 1, das ferner Folgendes umfasst: Ermitteln, ob das virtuelle FTF mit einem virtuellen Gerät und/oder einem Objekt in der Umgebung des virtuellen FTF kollidiert oder diesem zu nahe gekommen ist.

3. Verfahren nach Anspruch 2, wobei das Ermitteln, ob das virtuelle FTF mit einem virtuellen Gerät und/oder einem Objekt in der Umgebung des virtuellen FTF kollidiert oder diesem zu nahe gekommen ist, ferner Folgendes umfasst:
Ermitteln eines Abstands zwischen dem virtuellen FTF und dem virtuellen Gerät und/oder dem Objekt in der Umgebung des virtuellen FTF auf der Grundlage eines 3D-Modells von dem virtuellen FTF und eines 3D-Modells von dem virtuellen Gerät und/oder dem Objekt in der Umgebung des virtuellen FTF und
entsprechend dem ermittelten Abstand Ermitteln, ob das virtuelle FTF mit dem virtuellen Gerät und/oder dem Objekt in der Umgebung des virtuellen FTF kollidiert oder diesem zu nahe gekommen ist, wobei
das 3D-Modell von dem virtuellen FTF und das 3D-Modell von dem virtuellen Gerät und/oder dem Objekt in der Umgebung des virtuellen FTF jeweils Konturdaten von dem virtuellen FTF und dem virtuellen Gerät und/oder dem Objekt in der Umgebung des virtuellen FTF umfassen.

4. Verfahren nach Anspruch 1, das ferner Folgendes umfasst:
Anzeigen von 3D-Abbildungen von allen virtuellen FTF, virtuellen Geräten und Objekten in der Umgebung über eine Anzeigeschnittstelle entsprechend 3D-Modellen von allen virtuellen FTF, virtuellen Geräten und umgebenden Objekten in der Emulationsumgebung.

5. Vorrichtung zum Emulieren eines Systems mit fahrerlosen Transportfahrzeugen (FTF), die Folgendes umfasst:
eine Sensorerkennungseinheit, die so konfiguriert ist, dass sie Sensordaten für ein virtuelles FTF in einer Emulationsumgebung erfasst, wobei die Sensorerkennungseinheit ferner so konfiguriert ist, dass sie die Sensordaten auf der Grundlage eines Sensormodells von dem virtuellen FTF erfasst, wobei das Sensormodell von dem virtuellen FTF eine Position und Parameter eines virtuellen Sensors des virtuellen FTF umfasst,
eine Zustandsermittlungseinheit, die so konfiguriert ist, dass sie einen Gerätezustand eines virtuellen Geräts ermittelt, das mit dem virtuellen FTF in der Emulationsumgebung interagiert, ferner so konfiguriert ist, dass sie Zustandsdaten von dem virtuellen Gerät auf der Grundlage eines Sensormodells von dem virtuellen Gerät erfasst, wobei die Zustandsdaten eine Relativbewegung zwischen sich bewegenden Komponenten des virtuellen Geräts repräsentieren und das Sensormodell von dem virtuellen Gerät eine Position und Parameter eines virtuellen Sensors des virtuellen Geräts umfasst,
eine Datenaustauscheinheit, die so konfiguriert ist, dass sie die Sensordaten und den Gerätezustand zu dem FTF-System sendet und FTF-Bewegungssteuerungsinformationen und Gerätebetriebsinformationen aus dem FTF-System empfängt, wobei die FTF-Bewegungssteuerungsinformationen und die Gerätebetriebsinformationen auf der Grundlage der Sensordaten und des Gerätezustands von dem FTF-System generiert werden, und
eine Bewegungssteuereinheit, die so konfiguriert ist, dass sie auf der Grundlage der FTF-Bewegungssteuerungsinformationen beziehungsweise der Gerätebetriebsinformationen eine Bewegung des virtuellen FTF und des virtuellen Geräts in der Emulationsumgebung steuert, wobei die Steuereinheit ferner so konfiguriert ist, dass sie auf der Grundlage der FTF-Bewegungssteuerungsinformationen, eines kinematischen Modells von dem virtuellen FTF und aktueller Positionen der sich bewegenden Komponenten des virtuellen FTF nächste Positionen sich bewegender Komponenten des virtuellen FTF und auf der Grundlage der Gerätebetriebsinformationen, eines kinematischen Modells von dem virtuellen Gerät und aktueller Positionen der sich bewegenden Komponenten des virtuellen Geräts nächste Positionen von sich bewegenden Komponenten des virtuellen Geräts ermittelt, wobei die kinematischen Modelle von dem virtuellen FTF und dem virtuellen Gerät Bewegungsbeziehungen und Bewegungsparameter der sich bewegenden Komponenten des virtuellen FTF beziehungsweise des virtuellen Geräts umfassen.

6. Vorrichtung nach Anspruch 5, die ferner eine Kollisionserkennungseinheit umfasst, die so konfiguriert ist, dass sie ermittelt, ob das virtuelle FTF mit einem virtuellen Gerät und/oder einem Objekt in der Umgebung des virtuellen FTF kollidiert oder diesem zu nahe gekommen ist.

7. Vorrichtung nach Anspruch 6, wobei die Kollisionserkennungseinheit ferner so konfiguriert ist, dass sie:
auf der Grundlage eines 3D-Modells von dem virtuellen FTF und eines 3D-Modells von dem virtuellen Gerät und/oder dem Objekt in der Umgebung des virtuellen FTF einen Abstand zwischen dem virtuellen FTF und dem virtuellen Gerät und/oder dem Objekt in der Umgebung des virtuellen FTF ermittelt und
entsprechend dem ermittelten Abstand ermittelt, ob das virtuelle FTF mit dem virtuellen Gerät und/oder dem Objekt in der Umgebung des virtuellen FTF kollidiert oder diesem zu nahe gekommen ist, wobei
das 3D-Modell von dem virtuellen FTF und das 3D-Modell von dem virtuellen Gerät und/oder dem Objekt in der Umgebung des virtuellen FTF jeweils Konturdaten von dem virtuellen FTF und dem virtuellen Gerät und/oder dem Objekt in der Umgebung des virtuellen FTF umfassen.

8. Vorrichtung nach Anspruch 5, die ferner eine 3D-Rendering-Einheit umfasst, die so konfiguriert ist, dass sie entsprechend 3D-Modellen von allen virtuellen FTF, virtuellen Geräten und umgebenden Objekten in der Emulationsumgebung 3D-Abbildungen von allen virtuellen FTF, virtuellen Geräten und Objekten in der Umgebung über eine Anzeigeschnittstelle anzeigt.

9. Rechengerät, das Folgendes umfasst:
einen Prozessor und
einen Speicher, der so konfiguriert ist, dass er eine per Computer ausführbare Anweisung speichert, die, wenn sie ausgeführt wird, den Prozessor dazu veranlasst, das Verfahren nach einem der Ansprüche 1 bis 4 durchzuführen.

10. Computerlesbares Speichermedium, das eine darin gespeicherte per Computer ausführbare Anweisung umfasst, die dazu benutzt wird, das Verfahren nach einem der Ansprüche 1 bis 4 durchzuführen.

11. Computerprogrammprodukt, das physisch auf einem computerlesbaren Speichermedium gespeichert ist und eine per Computer ausführbare Anweisung umfasst, wobei die per Computer ausführbare Anweisung, wenn sie ausgeführt wird, mindestens einen Prozessor dazu veranlasst, das Verfahren nach einem der Ansprüche 1 bis 4 durchzuführen.

## Revendications

1. Procédé d'émulation d'un système de véhicule à guidage automatique (VGA), comprenant :
l'obtention de données de capteur d'un VGA virtuel dans un environnement d'émulation ; dans lequel ladite obtention comprend en outre l'obtention de données de capteur sur la base d'un modèle de capteur du VGA virtuel, le modèle de capteur du VGA virtuel comprenant une position et des paramètres d'un capteur virtuel du VGA virtuel ;
la détermination d'un état de dispositif d'un dispositif virtuel interagissant avec le VGA virtuel dans l'environnement d'émulation ; comprenant en outre l'obtention de données d'état du dispositif virtuel sur la base d'un modèle de capteur du dispositif virtuel, les données d'état représentant un mouvement relatif entre des composants mobiles du dispositif virtuel, et le modèle de capteur du dispositif virtuel comprenant une position et des paramètres d'un capteur virtuel du dispositif virtuel ; et la détermination de l'état de dispositif du dispositif virtuel en fonction des données d'état ;
l'envoi des données de capteur et de l'état de dispositif au système VGA, et la réception d'informations de commande de mouvement de VGA et d'informations de fonctionnement de dispositif en provenance du système VGA, dans lequel les informations de commande de mouvement de VGA et les informations de fonctionnement de dispositif sont générées par le système VGA sur la base des données de capteur et de l'état de dispositif ; et
la commande du mouvement du VGA virtuel et du dispositif virtuel dans l'environnement d'émulation sur la base des informations de commande de mouvement de VGA et des informations de fonctionnement de dispositif, respectivement ; dans lequel ladite commande de mouvement comprend en outre la détermination des positions suivantes de composants mobiles du VGA virtuel sur la base des informations de commande de mouvement de VGA, d'un modèle cinématique du VGA virtuel, et des positions actuelles des composants mobiles du VGA virtuel ; et la détermination des positions suivantes de composants mobiles du dispositif virtuel sur la base des informations de fonctionnement de dispositif, d'un modèle cinématique du dispositif virtuel, et des positions actuelles des composants mobiles du dispositif virtuel, dans lequel les modèles cinématiques du VGA virtuel et du dispositif virtuel comprennent des relations de mouvement et des paramètres de mouvement des composants mobiles du VGA virtuel et du dispositif virtuel, respectivement.

2. Procédé selon la revendication 1, comprenant en outre : la détermination si le VGA virtuel entre en collision avec ou est excessivement proche d'un dispositif virtuel et/ou d'un objet de l'environnement autour du VGA virtuel.

3. Procédé selon la revendication 2, dans lequel la détermination si le VGA virtuel entre en collision avec ou est excessivement proche d'un dispositif virtuel et/ou d'un objet de l'environnement autour du VGA virtuel comprend en outre :
la détermination d'une distance entre le VGA virtuel et le dispositif virtuel et/ou l'objet de l'environnement autour du VGA virtuel sur la base d'un modèle 3D du VGA virtuel et d'un modèle 3D du dispositif virtuel et/ou de l'objet de l'environnement autour du VGA virtuel ; et
la détermination, en fonction de la distance déterminée, si le VGA virtuel entre en collision avec ou est excessivement proche du dispositif virtuel et/ou de l'objet de l'environnement autour du VGA virtuel, dans lequel
le modèle 3D du VGA virtuel et le modèle 3D du dispositif virtuel et/ou de l'objet de l'environnement autour du VGA virtuel comprennent des données de contour du VGA virtuel et du dispositif virtuel et/ou de l'objet de l'environnement autour du VGA virtuel, respectivement.

4. Procédé selon la revendication 1, comprenant en outre :
l'affichage, en fonction des modèles 3D de tous les VGA virtuels, dispositifs virtuels et objets de l'environnement dans l'environnement d'émulation, d'images 3D de tous les VGA virtuels, dispositifs virtuels et objets de l'environnement à travers une interface d'affichage.

5. Appareil d'émulation d'un système de véhicule à guidage automatique (VGA), comprenant :
une unité de détection de capteur, configurée pour obtenir des données de capteur d'un VGA virtuel dans un environnement d'émulation ; dans lequel ladite unité de détection de capteur est en outre configurée pour obtenir les données de capteur sur la base d'un modèle de capteur du VGA virtuel, le modèle de capteur du VGA virtuel comprenant une position et des paramètres d'un capteur virtuel du VGA virtuel ;
une unité de détermination d'état, configurée pour déterminer un état de dispositif d'un dispositif virtuel interagissant avec le VGA virtuel dans l'environnement d'émulation ; configurée en outre pour obtenir des données d'état du dispositif virtuel sur la base d'un modèle de capteur du dispositif virtuel, les données d'état représentant un mouvement relatif entre des composants mobiles du dispositif virtuel, et le modèle de capteur du dispositif virtuel comprenant une position et des paramètres d'un capteur virtuel du dispositif virtuel ;
une unité de communication de données, configurée pour envoyer les données de capteur et l'état de dispositif au système VGA, et pour recevoir des informations de commande de mouvement de VGA et des informations de fonctionnement de dispositif en provenance du système VGA, dans lequel les informations de commande de mouvement de VGA et les informations de fonctionnement de dispositif sont générées par le système VGA sur la base des données de capteur et de l'état de dispositif ; et
une unité de commande de mouvement, configurée pour commander le mouvement du VGA virtuel et du dispositif virtuel dans l'environnement d'émulation sur la base des informations de commande de mouvement de VGA et des informations de fonctionnement de dispositif, respectivement ; dans lequel ladite unité de commande est en outre configurée pour déterminer les positions suivantes de composants mobiles du VGA virtuel sur la base des informations de commande de mouvement de VGA, d'un modèle cinématique du VGA virtuel, et des positions actuelles des composants mobiles du VGA virtuel ; et pour déterminer les positions suivantes de composants mobiles du dispositif virtuel sur la base des informations de fonctionnement de dispositif, d'un modèle cinématique du dispositif virtuel, et des positions actuelles des composants mobiles du dispositif virtuel, dans lequel les modèles cinématiques du VGA virtuel et du dispositif virtuel comprennent des relations de mouvement et des paramètres de mouvement des composants mobiles du VGA virtuel et du dispositif virtuel, respectivement.

6. Appareil selon la revendication 5, comprenant en outre une unité de détection de collision, configurée pour déterminer si le VGA virtuel entre en collision avec ou est excessivement proche d'un dispositif virtuel et/ou d'un objet de l'environnement autour du VGA virtuel.

7. Appareil selon la revendication 6, dans lequel l'unité de détection de collision est en outre configurée pour :
déterminer une distance entre le VGA virtuel et le dispositif virtuel et/ou l'objet de l'environnement autour du VGA virtuel sur la base d'un modèle 3D du VGA virtuel et d'un modèle 3D du dispositif virtuel et/ou de l'objet de l'environnement autour du VGA virtuel ; et
déterminer, en fonction de la distance déterminée, si le VGA virtuel entre en collision avec ou est excessivement proche du dispositif virtuel et/ou de l'objet de l'environnement autour du VGA virtuel, dans lequel
le modèle 3D du VGA virtuel et le modèle 3D du dispositif virtuel et/ou de l'objet de l'environnement autour du VGA virtuel comprennent des données de contour du VGA virtuel et du dispositif virtuel et/ou de l'objet de l'environnement autour du VGA virtuel, respectivement.

8. Appareil selon la revendication 5, comprenant en outre une unité de rendu 3D, configurée pour afficher, en fonction des modèles 3D de tous les VGA virtuels, dispositifs virtuels et objets de l'environnement dans l'environnement d'émulation, des images 3D de tous les VGA virtuels, dispositifs virtuels et objets de l'environnement à travers une interface d'affichage.

9. Dispositif informatique, comprenant :
un processeur ; et
une mémoire, configurée pour stocker une instruction exécutable par ordinateur, l'instruction exécutable par ordinateur, lorsqu'elle est exécutée, amenant le processeur à effectuer le procédé selon l'une quelconque des revendications 1 à 4.

10. Support de stockage lisible par ordinateur, comprenant une instruction exécutable par ordinateur stockée dans celui-ci, l'instruction exécutable par ordinateur étant utilisée pour effectuer le procédé selon l'une quelconque des revendications 1 à 4.

11. Produit de programme informatique, stocké concrètement dans un support de stockage lisible par ordinateur et comprenant une instruction exécutable par ordinateur, l'instruction exécutable par ordinateur, lorsqu'elle est exécutée, amenant au moins un processeur à effectuer le procédé selon l'une quelconque des revendications 1 à 4.
